# EUROPEAN PATENT SPECIFICATION

(11) **EP 1 174 455 B1**
(45) Date of publication and mention of the grant of the patent: **29.09.2004**
(21) Application number: 01117045.3
(22) Date of filing: 12.07.2001
(51) Int. Cl.: C08G 59/08, C08G 59/62, H01L 23/28, H01L 23/29

(54) **Epoxy resin composition for encapsulating semiconductor**
Epoxyharzzusammensetzung zum Verkapseln von Halbleitern
Composition de resine epoxy pour encapsuler des composants a semiconductrices

(30) Priority: 19.07.2000 JP 2000218860
(43) Date of publication of application: 23.01.2002
(73) Proprietor: Sumitomo Chemical Company, Limited, Chuo-ku Osaka 541-8550 (JP)
(72) Inventor: Endo, Kazuhisa, Tsukuba-shi, Ibaraki (JP); Nakajima, Nobuyuki, Niihama-shi, Ehime (JP); Saito, Noriaki, Toyonaka-shi, Osaka (JP)
(74) Representative: Henkel, Feiler & Hänzel

(56) References cited:
- EP-A- 0 424 872
- EP-A- 0 536 748
- EP-A- 0 536 749
- EP-A- 0 567 919
- US-A- 4 960 634

## Description

### BACKGROUND OF THE INVENTION

### Field of the Invention

The present invention relates to an epoxy resin composition having low moisture absorption and excellent solder-crack resistance. The composition is useful as an adhesive, a coating material, electric and electronic material such as an encapsulating material and a laminated board, especially useful for encapsulating an electronic device.

### Description of the Related Art

In recent years, transfer molding of a useful epoxy resin composition is economically performed for encapsulating of semiconductors, such as LSI, IC, and a transistor. Particularly, surface mounting of LSI is recently conducted and direct immersion into a solder bath is increasing.
Since an encapsulating material is exposed to a high temperature of 200 °C or more in this treatment, moisture absorbed in the encapsulating material expands, cracks are formed and peeling occurs at the interface with a die pad.

For this reason, the epoxy resin encapsulating material is required for improvement of low moisture absorption, solder-crack resistance, and adhesion.

In the present situation, an encapsulating material in which glycidyl ether of o-cresol novolak is mainly used as a polyfunctional epoxy resin and a phenol novolak is mainly used as a curing agent. However, when the encapsulating material absorbs moisture in storage, the above-mentioned problems occur. In order to avoid these problems, moisture proof packing is carried out in practical use.

Besides the glycidyl ether of o-cresol novolak, JP-A 60-112813 describes a glycidyl ether of novolak in which phenols are combined with p-xylylene skeleton, but neither the hygroscopic property nor the solder-crack resistance is sufficient enough.

Furthermore, JP-A 5-222156 describes that a glycidyl ether of aralkyl phenol is excellent in heat resistance or a low dielectric property for laminated boards, but the low moisture absorption and the solder-crack resistance, etc., required for encapsulating, are not sufficient.

EP-A-0 536 748 discloses polyhydric phenols which are starting materials for glycidyl ether compounds which can provide cured products having low moisture absorption, high heat resistance and improved crack resistance and can be used for encapsulating semiconductor devices. The polyhydric phenols are represented by the following formula: 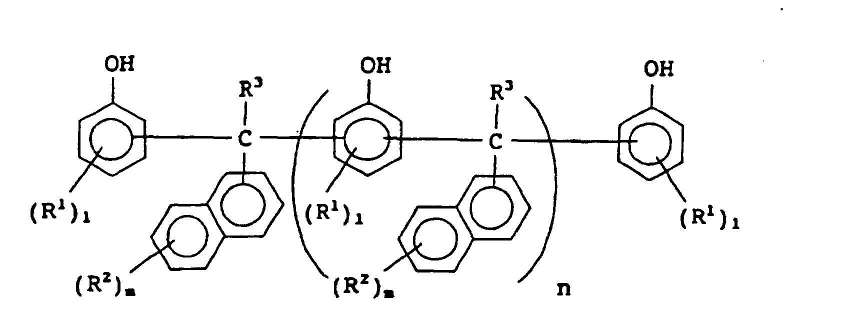 wherein R¹ independently represents a halogen atom, an alkyl or cycloalkyl group of 1-9 carbon atoms, an alkoxy group of 4 or less carbon atoms or an aryl group and R¹ may be identical or different when 1 is 2 or more, R² independently represents a halogen atom, an alkoxy group of 4 or less carbon atoms or an alkyl group of 6 or less carbon atoms and R₂ may be identical or different when m is 2 or more, R³ independently represents a hydrogen atom or an alkyl group of 6 or less carbon atoms, the average recurring unit number n is 0-10, 1 is 0-4 and m is 0-7, and can be contained as a curing agent in an epoxy resin composition which is used not only for giving cured products but also for encapsulating semiconductor devices.

EP-A-0 567 919 discloses an epoxy resin composition having a lower hygroscopicity and a good balance between the heat-resistance, curability and adhesiveness and a resin-encapsulated semiconductor device produced by using the same composition, which epoxy resin composition comprises an epoxy resin having at least two epoxy groups in a molecule and a polyhydric phenol represented by the following general formula:

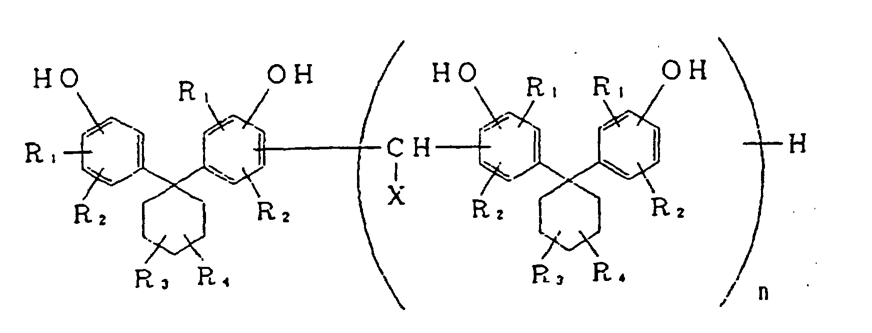

US-A-4 960 634 discloses a composition comprising:
(A) about 70 to 90 parts per 100 parts by weight of resin solids of a tetrabrominated diglycidyl ether of a phenol polyepoxide;
(B) about 10 to about 30 parts per 100 parts by weight of resin solids of an epoxy polymer having functionality of about 3.5 to about 6;
(C) about 40 to about 75 parts by weight per 100 parts of resin solids of zinc oxide;
(D) about 3 to about 4 parts per 100 parts by weight of resin solids of dicyandiamide; and
(E) about 0.2 to about 0.4 parts per 100 parts by weight of resin solids of a tertiary amine.

### SUMMARY OF THE INVENTION

An object of the present invention is to provide an epoxy resin composition having low moisture absorption and excellent solder-crack resistance, and resin-encapsulated type semiconductor apparatus using the same. The composition is useful as an adhesive, a coating material, electric and electronic material such as an encapsulating material and a laminated board, especially useful for encapsulating an electronic device.

As a result of extensive studies in view of aforementioned circumstances, the present inventors have found that the above-mentioned problems can be solved by using a specific epoxy resin composition and completed the present invention.

Namely, the present invention is directed to an epoxy resin composition for encapsulating semiconductor comprising:
(A) an epoxy resin having two or more epoxy groups in a molecule. represented by formula (1), 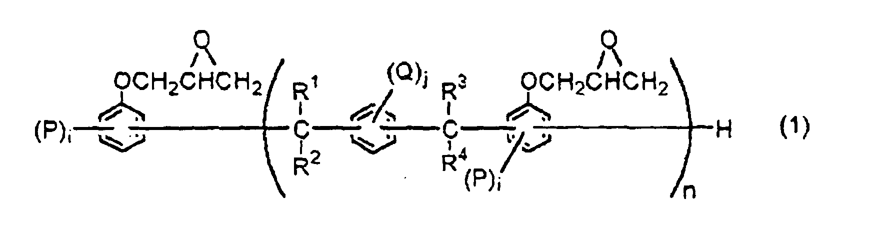 in the formula, n is an average number of the repeating units, and represents a numerical value of 1 or more to 20 or less; R¹, R², R³, and R⁴ independently represent, hydrogen atom, an alkyl group having 1-8 carbon atoms, a cycloalkyl group having 5-12 carbon atoms, an aryl group having 6-12 carbon atoms, or an aralkyl group having 7-20 carbon atoms ; P and Q independently represent. halogen atom, an alkyl group having 1-8 carbon atoms, an alkenyl group having 1-8 carbon atoms, an alkynyl group having 1-8 carbon atoms, a cycloalkyl group having 5-12 carbon atoms, an aryl group having 6-14 carbon atoms, an aralkyl group having 7-20 carbon atoms, an alkoxy group having 1-8 carbon atoms, an alkenyloxy group having 1-8 carbon atoms, an alkynyloxy group having 1-8 carbon atoms, an aryloxy group having 6-14 carbon atoms, nitro group or cyano group; when n is 1, i is an integer of 0 to 4, and when n is not 1, i is an integer of 0 to 3; j is an integer of 0 to 4; all of R¹, R² R³, and R⁴ are not hydrogen atoms at the same time.
(B) a curing agent having a phenolic hydroxyl group, and
(C) inorganic filler in an amount of 60 to 98% by weight based on the whole composition.

Further the present invention is directed to a resin-encapsulated type semiconductor apparatus, wherein the semiconductor device is encapsulated by curing the above epoxy resin composition.

### Detailed Description of the Invention

The epoxy resin (A) used for the present invention is a compound represented by the above formula (1). Suitably, in the above formula (1), R¹, R², R³, and R⁴ independently represent alkyl groups having 1-4 carbon atoms, cycloalkyl groups having 5-7 carbon atoms, or aryl groups having 6-9 carbon atoms. More suitably, all of R¹, R², R³, and R⁴ are methyl groups, further suitably, all Qs are hydrogen atoms, and most suitably, a glycidyl ether of aralkyl phenol represented by the following formula (2). 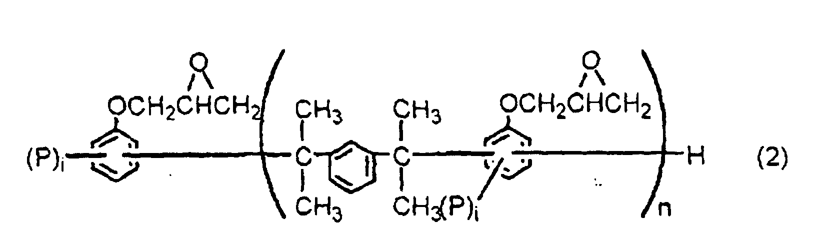 in the formula, P, i and n represent the same meaning as the above.

The compound represented by formula (3) which is a precursor of the epoxy resin represented by formula (1) can be prepared using the method shown in JP-A 58-121230, JP-A 58-121231, JP-A 63-303939, etc. 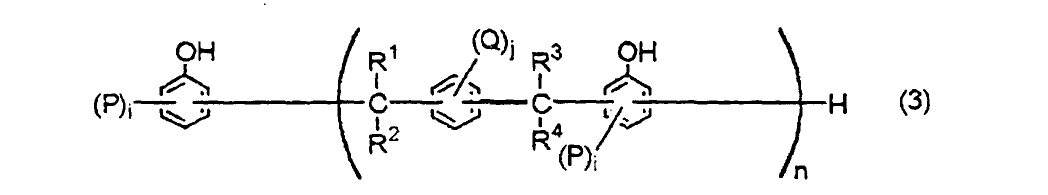 In the formula, R¹, R², R³, R⁴, P, Q, i, j, and n represent the same meaning as the above.

As a general preparation process of the compound represented by the above formula (3), without being limited, compounds represented by diisopropenyl benzene, bis ( α - hydroxyisopropyl) benzene, 1-isopropenyl-3- α -hydroxy isopropylbenzene, 1-isopropenyl-2- α -hydroxy isopropylbenzene, 1-isopropenyl-4- a -hydroxy isopropylbenzene, and substituted aromatic derivatives thereof, are reacted with phenols under existence of a acid catalyst. By reacting the compound represented by the above formula (3) with an epihalohydrin, an epoxy resin of the above formula (1) can be obtained, without being limited thereto.

Phenols are compounds which have at least one phenolic hydroxyl group. Examples thereof include: phenol; various o-, m- and p-isomers of alkyl phenol represented with cresol, ethylphenol, n-propylphenol, isopropylphenol, n-butyl phenol, isobutylphenol, t-butylphenol, octylphenol, nonyl phenol, xylenol, methylbutylphenol, di-t-butylphenol, di-t-amylphenol, etc.; various o-, m- and p-isomers of alkenyl or alkynylphenol represented with vinylphenol, allylphenol, propenylphenol, ethynylphenol, etc.; various o- , m- and p-isomers of alkoxy, alkenyloxy or alkynyloxy phenol represented with methoxyphenol, ethoxyphenol, aryloxy phenol, propargyloxyphenol, etc.; cycloalkylphenol represented with cyclopentylphenol, cyclohexylphenol, cyclohexylcresol, etc.; halogen substituted phenols represented with chlorophenol, dichlorophenol, bromophenol, dibromophenol, etc.; and substituted phenols, such as nitrophenol, cyano phenol, aryl phenol, and aralkyl phenol.

Among the above phenols, phenol, various o-, m- and p-isomers of cresol, various o-, m- and p-isomers of xylenol and 3-methyl-6-t-butyl phenol can be exemplified more suitably.

As a curing agent, a well-known curing agent can be used in the present invention. Examples thereof include, without being limited, polyhydric phenols such as phenol novolak, cresol novolak, fluoroglycine, tris(4-hydroxyphenyl)methane, 1,1,1-trishydroxyphenylethane, and 1,1,2,2-tetrakis(4-hydroxyphenyl)ethane.

Further examples of polyhydric phenols as the above-mentioned curing agent for epoxy resin include: polycondensation products of phenols such as phenol, various alkyl phenols, and naphthols as alone or in combination of two or more, with aldehydes, such as formaldehyde, acetaldehyde, acrolein, glyoxal, benzaldehyde, naphthoaldehyde, andhydroxy benzaldehyde or ketones, such as cyclohexanone and acetophenone; vinyl polymerization type polyhydric phenols, such as poly vinylphenol and polyisopropenyl phenol; reaction products of phenols with diols such as represented by the formula (4), dialkoxy compounds, such as represented by the formula (5), or dihalogen compounds, such as represented by the formula (6), 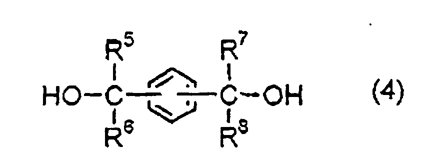 (in the formula, R⁵, R⁶, R⁷, and R⁸ independently represent, hydrogen atom, acyclic or cyclic alkyl group having 1-6 carbon atoms, substituted or unsubstituted phenyl group), 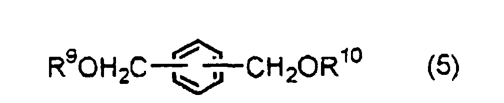 (in the formula, R⁹ and R¹⁰ independently represent, hydrogen atom, acyclic or cyclic alkyl group having 1-6 carbon atoms, or substituted or unsubstituted phenyl group), 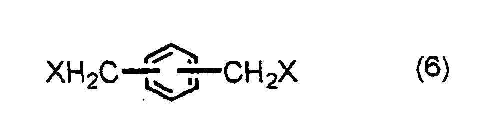 (in the formula, X represents fluorine, chlorine, bromine, or iodine);
or Friedel-Crafts type reaction products of phenols with alicyclic compounds such as phenol, dicyclopentadiene, and limonene, or diolefins such as diisopropenylbenzene, etc., without being limited thereto.

In view of hardenability, a polyhydric phenol is used suitably. In addition, these curing agents can be used alone or in combination of two or more.

About the formulation rate of an epoxy curing agent to an epoxy resin, 0.3 to 1.2 equivalent to an epoxy group is usually suitable.

When the epoxy resin composition of the present invention is cured, a well-known curing accelerator can be used. Examples of the curing accelerator include, without being limited: organic phosphine compounds, such as tri phenyl phosphine, tri-4-methylphenyl phosphine, tri-4-methoxy phenyl phosphine, tri butyl phosphine, trioctyl phosphine, and tri-2-cyano ethyl phosphine, and tetraphenylborate salts thereof; tertiary amines, such as tributylamine, triethylamine, 1,8-diazabicyclo[5.4.0]undecene-7, and triamylamine, quarternary ammonium salts, such as benzylchloride trimethyl ammonium, benzyltrimethylammonium hydroxide, and triethyl ammonium tetraphenylborate; and imidazole.

Among them, organic phosphine compound, 1,8-diazabicyclo [5.4.0]undecene-7, and imidazole are suitable from the point of moisture resistance and hardenability. Triphenyl phosphine is especially suitable.

Examples of (C) inorganic filler in the epoxy resin composition include silica, alumina, titanium white, aluminum hydroxide, talc, clay, glass fiber, etc., and silica and alumina are suitable. These can be used by mixing those having different forms (spherical shape or crushed type) or sizes to increase the filling amount, and it is preferable to use a mixture of inorganic fillers having spherical shape and crushed form.

When compounding inorganic fillers, the amount is 60 % by weight or more and 98 % by weight or less based on the whole amount of the resin composition, suitably 70 % by weight or more and 98 % by weight or less, and more suitably 75 % by weight or more and 98 % by weight or less.

In the epoxy resin composition of the present invention, can be added according to requirements are: mold lubricants, such as natural wax, synthetic wax, higher fatty acid and metal salts thereof or paraffin; colorants such as carbon black; and surface treatment agents, such as silane coupling agent, etc. Moreover, flame retardants, such antimony trioxide, a phosphorous compound, and a brominated epoxy resin can be added. In order to obtain a flame retardant effect, a brominated epoxy resin is especially preferable.

For lowering stress, various elastomers may be added or previously reacted for use. Examples thereof include addition type or reaction type elastomers and the like such as polybutadiene, butadiene-acrylonitrile copolymer, silicone rubber, silicone oil and the like.

For encapsulating an electronic device such as semiconductor's etc. using the epoxy resin composition by the present invention and making a resin-encapsulated type semiconductor apparatus, cure-molding can be carried out by conventionally well-known molding methods, such as transfer molding, compression molding, and injection molding.

For curing the epoxy resin composition of the present invention, a formulation rate and the kind of catalysts, etc. can be selected appropriately. Usually the curing is conducted at a temperature in the range of 100 °C - 200 °C, for 1 to 24 hours.

In the resin-encapsulated type semiconductor apparatus of the present invention, the semiconductor device is encapsulated with curing the epoxy resin composition of the present invention, and well-known materials etc. except as the epoxy resin composition, can be used for semiconductor devices. Curing condition of the epoxy resin composition is not especially limited, as long as the semiconductor device can be encapsulated, and usually carried out in a range of the above-mentioned curing condition.

### EXAMPLES

Although examples of the present invention are shown below, the present invention is not limited to these.

Evaluation methods of the resin and cure-molded material are as follows.
Softening point : Measured by ring and ball method, according to JIS K7234.
Gel time : Measured at 175 °C according to JIS K5909.
Spiral Flow : Measured at 175 °C and 70kg/cm², according to EMMI-1-66.
Pulling out adhesive strength : Measured at room temperature, according to JP-A 9-100339.
Solder-crack resistance : Imitation IC (52 pin QFP package: package thickness 2.05mm ) is used, and immediately after moisture is absorbed under the condition of 60%RH, 85 °C for 168 hours, in a thermo-hygrostat (Advantec Toyo Co. AGX-326), immersing in a solder bath of 240°C for 30 seconds, and examined the rate of excellent articles. The excellent articles mean those which have no cracks and peelings. The rate of excellent article is a number of excellent article packages to the total number of packages.
Water absorption : Using the package used for the solder-crack resistance mentioned above, the weight change was measured before moisture absorption and after moisture absorption.

In the example, epoxy equivalent is defined as the weight of the epoxy resin per one epoxy group. OH equivalent is defined as the weight of OH compound per one OH group.

### Synthetic Example 1 (Synthesis of a raw material novolak)

This example is related with a process of preparing novolak represented by formula (3), wherein R¹=R²=R³=R⁴=CH₃, i=0, and j=0.

To a 2-liters four-necked round flask equipped with a thermometer, an agitator, and a condenser having a partitioning pipe, 225.9g(2.4mol) of phenol, 388.5g(2.0mol) of 1,3-bis (2-hydroxy-2-propyl)benzene, 7.60g(0.04mol) of p-toluenesulfonic acid mono-hydrate, and 614g of toluene were charged, and stirred at 116 °C for 9 hours. During stirring, azeotropically vaporizing toluene and water were liquefied with cooling, and the reaction was continued with returning the organic layer in the reaction system. Then, after cooling to 85 °C, 2.57g(0.0315mol) of 49% sodium hydroxide aqueous solution and 460.8g of hot water were added , and neutralized. After separating the aqueous layer, 487.0g of aralkyl phenol novolak was obtained by distilling the solvent and unreacted phenol under a reduced pressure.

### Synthetic Example 2 (Synthesis of epoxy resin 1)

This example is related with a process of preparing an epoxy resin represented by formula (1), wherein R¹=R²=R³=R⁴=CH₃, i=0, and j=0.

To a reaction container equipped with a thermometer, an agitator, and a condenser having a partitioning pipe, 192.1g of the aralkyl phenol novolak obtained in Synthetic Example 1, 1101g of epichlorohydrin, 385.3g of 1,4-dioxane and 14.9g of water were charged and dissolved. Keeping the reaction system at 39 °C, 19.67g of 48.5% potassium hydroxide aqueous solution was added continuously in one hour. Then, keeping at 8000Pa (60torr), the reaction was continued at 39 °C for 3.5 hours. In the meantime, maintaining the temperature at 39 °C, azeotropically vaporizing epichlorohydrin and water were liquefied with cooling, and the reaction was continued with returning the organic layer in the reaction system. Then, 52.78g of 49% sodium hydroxide aqueous solution was added continuously in 3.5 hours, keeping at 62.5 °C and 20000Pa (150torr). In the meantime, maintaining the temperature at 62.5 °C, azeotropically vaporizing epichlorohydrin and water were liquefied with cooling, and the reaction was continued with returning the organic layer in the reaction system. Keeping 20000Pa (150torr), the reaction was continued at 64.5 °C for 0.5 hours. In the meantime, maintaining the temperature at 64.5 °C, azeotropically vaporizing epichlorohydrin and water were liquefied with cooling, and the reaction was continued with returning the organic layer in the reaction system.

After the reaction, unreacted epichlorohydrin was removed by vacuum concentration, dissolved in 559g of methylisobutyl ketone, and the by-produced salt was removed by washing with water. Keeping at 81 °C, 4.41g of 49% sodium hydroxide aqueous solutions was added, and the reaction was continued for 2 hours. Then, 4.75g of dry ice was added, and neutralized. After separating the by-produced salt by filtration, distilling the solvent by vacuum concentration, 182.2g of epoxy resin (hereafter referred to as epoxy 1) was obtained. The softening point, the epoxy equivalent and hydrolyzable chlorine of the epoxy 1 were 74 °C, 336g/eq, and 230 ppm, respectively.

### Referential Synthetic Example (Synthesis of epoxy resin 2)

This example is related with a process of preparing an epoxy resin represented by formula (1), wherein R¹=R²=R³=R⁴=H, i=0, and j=0.

To a reaction container equipped with a thermometer, an agitator, and a condenser having a partitioning pipe, 256.5g of aralkyl phenol novolak (trade name Mirex XLC-4L, produced by Mitsui Chemicals Inc. , OH equivalent of 171g/eq, softening point of 61 °C, and represented by the below formula (7)), 1360g of epichlorohydrin and 27.2g of water were charged and dissolved.

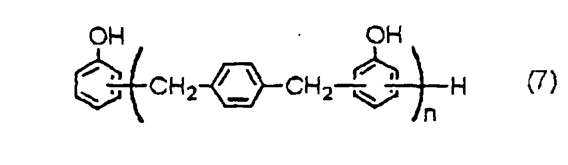

Keeping the reaction system at 50 °C, 38.18g of 48.5% potassium hydroxide aqueous solution was added continuously in one hour. Then, keeping at 8000Pa (60torr), the reaction was continued at 50 °C for 3.5 hours. In the meantime, maintaining the temperature at 39 °C, azeotropically vaporizing epichlorohydrin and water were liquefied with cooling, and the reaction was continued with returning the organic layer in the reaction system. Keeping 20000Pa (150torr), the reaction was continued at 62.5 °C for 2 hours. In the meantime, maintaining the temperature at 62.5 °C, azeotropically vaporizing epichlorohydrin and water were liquefied with cooling, and the reaction was continued with returning the organic layer in the reaction system.

Then, 91.91g of 49% sodium hydroxide aqueous solution was added continuously in 3.5 hours, keeping at 62.5 °C and 20000Pa (150torr). In the meantime, maintaining the temperature at 62.5 °C, azeotropically vaporizing epichlorohydrin and water were liquefied with cooling, and the reaction was continued with returning the organic layer in the reaction system. Keeping 20000Pa (150torr), the reaction was continued at 64.5 °C for 0.5 hours. In the meantime, maintaining the temperature at 64.5 °C, azeotropically vaporizing epichlorohydrin and water were liquefied with cooling, and the reaction was continued with returning the organic layer in the reaction system.

After the reaction, unreacted epichlorohydrin was removed by vacuum concentration, dissolved in 559g of methylisobutyl ketone, and the by-produced salt was removed by washing with water. Keeping at 81 °C, 6.27g of 49% sodium hydroxide aqueous solutions was added, and the reaction was continued for 2 hours.

Then, 6.76g of dry ice was added, and neutralized. After separating the by-produced salt by filtration, distilling the solvent by vacuum concentration, 319.4g of epoxy resin (hereafter referred to as epoxy 2) was obtained. The softening point, the epoxy equivalent and hydrolyzable chlorine of the epoxy 2 were 39 °C, 229g/eq, and 510 ppm, respectively.

### Examples 1-3 and Comparative Examples 1-2

Using Epoxy 1 obtained in Synthetic Example 2, Epoxy 2 obtained in Referential Synthetic Example, or an orthocresol novolak type epoxy resin (trade name "ESCN195LL" produced by Sumitomo Chemical Co., Ltd., hereinafter referred to as Epoxy 3) as an epoxy resin, phenol novolak (trade name PSM-4261, produced by Gun-ei Chemical Industry Co., Ltd.) as a curing agent, triphenylphosphine as a curing accelerator, and fused silica as a filler, 1.5 % by weight of carnauba wax as a mold lubricant, and 2 % by weight of a coupling agent (trade name SH-6040, produced by Toray Dow Corning Co.) were compounded in a composition ratio shown in Table 1, and after heat-kneading by roll, transfer molding was carried out.

As the above fused silica, a mixture of crushed silica (trade name FS-891, produced by Denki Kagaku Kogyo K.K.) 20 % by weight to the whole silica, and spherical silica (trade name FB-60, produced by Denki Kagaku Kogyo K.K., the mean particle diameter of 25 *µ*m) 80 % by weight of to the whole silica was used. The mixture was used as a filler in a compounding amount (% by weight to the whole composition) shown in Table 1.

From Table 1, Examples 1 to 3 show a good result in performances, such as a hygroscopic resistance, a solder-crack resistance, and adherence, comparing with Comparative Examples 1 to 2.

The epoxy resin composition of the present invention is excellent in low moisture absorption and adherence. Moreover, the epoxy resin composition of the present invention is excellent in a solder-crack resistance, it is used as an excellent resin composition for encapsulating a semiconductor.

**Table 1**

| | Example 1 | Example 2 | Example 3 | Comparative Example 1 | Comparative Example 2 |
|---|---|---|---|---|---|
| Epoxy 1 (part by weight) | 100 | 100 | 100 | 0 | 0 |
| Epoxy 2 (part by weight) | 0 | 0 | 0 | 100 | 0 |
| Epoxy 3 (part by weight) | 0 | 0 | 0 | 0 | 100 |
| Phenol novolak (part by weight) | 32 | 32 | 32 | 46 | 53 |
| Triphenylphosphine (part by weight) | 3.5 | 3.5 | 3 | 1.25 | 1.5 |
| Silica (% by weight) | 78 | 80 | 82 | 80 | 82 |
| Gel time (seconds) | 22 | 23 | 38 | 37 | 31 |
| Spiral flow (cm) | 77 | 67 | 50 | 107 | 81 |
| Pulling out adhesive strength (MPa) | 10.8 | 8.25 | 9.68 | 7.22 | 4.73 |
| Water absorption (%) | 0.15 | 0.14 | 0.14 | 0.17 | 0.22 |
| Solder-crack resistance | 9/10 | 8/10 | 10/10 | 2/20 | 0/10 |

## Claims

1. An epoxy resin composition for encapsulating semiconductor comprising:
(A) an epoxy resin having two or more epoxy groups in a molecule represented by formula (1), 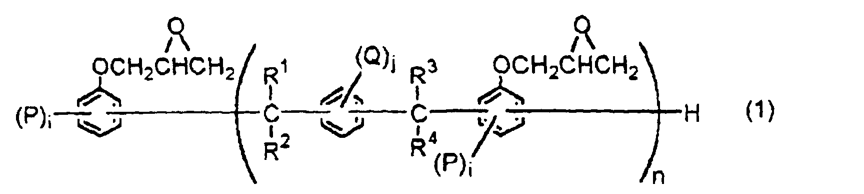 in the formula, n is an average number of the repeating units, and represents a numerical value of 1 to 20; R¹, R², R³, and R⁴ independently represent, hydrogen atom, an alkyl group having 1-8 carbon atoms, a cycloalkyl group having 5-12 carbon atoms, an aryl group having 6-12 carbon atoms, or an aralkyl group having 7-20 carbon atoms; P and Q independently represent, halogen atom, an alkyl group having 1-8 carbon atoms, an alkenyl group having 1-8 carbon atoms, an alkynyl group having 1-8 carbon atoms, a cycloalkyl group having 5-12 carbon atoms, an aryl group having 6-14 carbon atoms, an aralkyl group having 7-20 carbon atoms, an alkoxy group having 1-8 carbon atoms, an alkenyloxy group having 1-8 carbon atoms, an alkynyloxy group having 1-8 carbon atoms, an aryloxy group having 6-14 carbon atoms, nitro group or cyano group; when n is 1, i is an integer of 0 to 4, and when n is not 1, 1 is an integer of 0 to 3; j is an integer of 0 to 4; all of R¹, R², R³, and R⁴ are not hydrogen atoms at the same time,
(B) a curing agent having a phenolic hydroxyl group, and
(C) inorganic filler in an amount of 60 to 98% by weight based on the whole composition.

2. A resin-encapsulated type semiconductor apparatus, wherein the semiconductor device is encapsulated by curing the epoxy resin composition of claim 1.

## Patentansprüche

1. Epoxyharzzusammensetzung zur Einkapselung von Halbleitern, die umfasst:
(A) ein Epoxyharz mit zwei oder mehreren Epoxygruppen in einem Molekül der Formel (1) 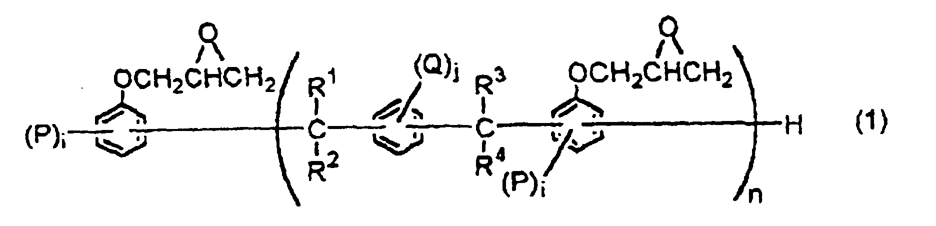 wobei in der Formel n die durchschnittliche Zahl der Wiederholungseinheiten ist und einen Zahlenwert von 1 bis 20 bedeutet; R¹, R², R³ und R⁴ unabhängig voneinander ein Wasserstoffatom, eine Alkylgruppe mit 1 - 8 Kohlenstoffatomen, eine Cycloalkylgruppe mit 5 - 12 Kohlenstoffatomen, eine Arylgruppe mit 6 - 12 Kohlenstoffatomen oder eine Aralkylgruppe mit 7 - 20 Kohlenstoffatomen bedeuten; P und Q unabhängig voneinander ein Halogenatom, eine Alkylgruppe mit 1 - 8 Kohlenstoffatomen, eine Alkenylgruppe mit 1 - 8 Kohlenstoffatomen, eine Alkinylgruppe mit 1 - 8 Kohlenstoffatomen, eine Cycloalkylgruppe mit 5 - 12 Kohlenstoffatomen, eine Arylgruppe mit 6 - 14 Kohlenstoffatomen, eine Aralkylgruppe mit 7 - 20 Kohlenstoffatomen, eine Alkoxygruppe mit 1 - 8 Kohlenstoffatomen, eine Alkenyloxygruppe mit 1 - 8 Kohlenstoffatomen, eine Alkinyloxygruppe mit 1- 8 Kohlenstoffatomen, eine Aryloxygruppe mit 6 - 14 Kohlenstoffatomen, eine Nitrogruppe oder eine Cyanogruppe bedeuten; wenn n 1 ist, i eine ganze Zahl von 0 bis 4 bedeutet, und wenn n nicht 1 ist, i eine ganze Zahl von 0 bis 3 bedeutet; j eine ganze Zahl von 0 bis 4 bedeutet; alle Reste R¹, R², R³ und R⁴ nicht gleichzeitig Wasserstoffatome sind,
(B) ein Härtungsmittel mit einer phenolischen Hydroxylgruppe und
(C) einen anorganischen Füllstoff in einer Menge von 60 bis 98 Gew.-%, bezogen auf die gesamte Zusammensetzung.

2. Halbleiterapparatur des harzeinkapselten Typs, wobei die Halbleitervorrichtung durch Härten der Epoxyharzzusammensetzung nach Anspruch 1 einkapselt wird.

## Revendications

1. Composition de résine époxy destinée à encapsuler des semi-conducteurs comprenant :
(A) une résine époxy contenant deux groupes époxy ou plus par molécule représentée par la formule (1), 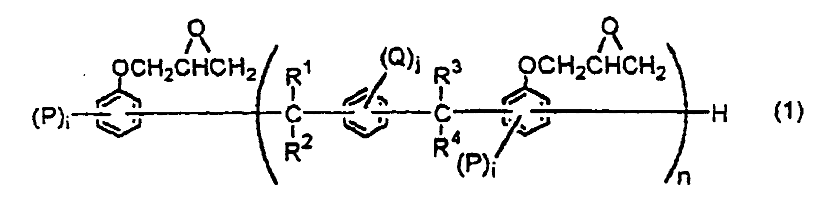 dans la formule, n représente le nombre moyen de motifs répétés et a une valeur numérique de 1 à 20 ; R¹, R², R³ et R⁴ représentent indépendamment un atome d'hydrogène, un groupe alkyle comportant 1 à 8 atomes de carbone, un groupe cycloalkyle comportant 5 à 12 atomes de carbone, un groupe aryle comportant 6 à 12 atomes de carbone, ou un groupe aralkyle comportant 7 à 20 atomes de carbone ; P et Q représentent indépendamment un atome d'halogène, un groupe alkyle comportant 1 à 8 atomes de carbone, un groupe alcényle comportant 1 à 8 atomes de carbone, un groupe alcynyle comportant 1 à 8 atomes de carbone, un groupe cycloalkyle comportant 5 à 12 atomes de carbone, un groupe aryle comportant 6 à 14 atomes de carbone, un groupe aralkyle comportant 7 à 20 atomes de carbone, un groupe alcoxy comportant 1 à 8 atomes de carbone, un groupe alcényloxy comportant 1 à 8 atomes de carbone, un groupe alcynyloxy comportant 1 à 8 atomes de carbone, un groupe aryloxy comportant 6 à 14 atomes de carbone, un groupe nitro ou un groupe cyano ; lorsque n est égal à 1, i représente un nombre entier de 0 à 4, et lorsque n n'est pas égal à 1, i représente un nombre entier de 0 à 3 ; j représente un nombre entier de 0 à 4 ; R¹, R³, R² et R⁴ ne représentent pas tous en même temps des atomes d'hydrogène,
(B) un agent de durcissement ayant un groupe hydroxyle phénolique, et
(C) une charge inorganique en une quantité de 60 à 98 % en poids par rapport à la composition totale.

2. Appareil à semi-conducteur de type encapsulé par une résine dans lequel le dispositif semi-conducteur est encapsulé par durcissement de la composition de résine époxy de la revendication 1.
